(19) Europäisches Patentamt

European Patent Office

Office européen des brevets

(11) Publication number: **0 201 240 B1**

# EUROPEAN PATENT SPECIFICATION

(45) Date of publication of patent specification: **23.09.92**   (51) Int. Cl.⁵: **B65G  47/91**, H01L 21/68, H05K 13/00

(21) Application number: **86303061.5**

(22) Date of filing: **23.04.86**

(54) **Apparatus for supporting and/or conveying a plate with fluid without physical contact.**

(30) Priority: **04.05.85 JP 95743/85**
**15.07.85 JP 156817/85**
**26.07.85 JP 115402/85**
**09.08.85 JP 122865/85**

(43) Date of publication of application:
**12.11.86 Bulletin  86/46**

(45) Publication of the grant of the patent:
**23.09.92 Bulletin  92/39**

(84) Designated Contracting States:
**DE FR GB SE**

(56) References cited:
**DE-A- 1 531 192**
**GB-A- 2 091 698**
**US-A- 3 466 079**
**US-A- 3 523 706**

**IBM TECHNICAL DISCLOSURE BULLETIN, vol. 22, no. 8A, January 1980, pages 3370-3371; R.D. COLES "Self-centering non-contact pick-up"**

**PATENT ABSTRACTS OF JAPAN, vol. 7, no. 255 (E-210)[1400], 12th November 1983; & JP -**

**A - 58 141 536 (SANYO DENKI K.K.) 22-08-1983**

(73) Proprietor: **KABUSHIKI KAISHA SEIBU GIKEN**
**1043-5 Wada Sasaguri-machi**
**Kasuya-gun Fukuoka-Ken(JP)**

Proprietor: **Kuma, Tosimi**
**25-8 3-chome Maimatsubara Higashi-ku**
**Fukuoka-shi Fukuoka-ken(JP)**

(72) Inventor: **Kuma, Tosimi**
**25-8 3-chome Maimatsubara Higashi-ku**
**Fukuoka-shi GFukuoka-ken(JP)**

(74) Representative: **Seaborn, George Stephen et al**
**c/o Edward Evans & Co. Chancery House**
**53-64 Chancery Lane**
**London WC2A 1SD(GB)**

# Description

## BACKGROUND OF THE INVENTION

### FIELD OF THE INVENTION

The present invention relates to an apparatus for supporting and/or conveying a plate with fluid without physical contact. It is especially useful for supporting and/or conveying plates such as silicone wafer and floppy disc whose surface should be protected from minute scratches or contamination without physical contact in fluids such as air and conveying them if necessary in the floating state.

## DESCRIPTION OF THE PRIOR ART

US-A-3 466 079 discloses an apparatus for supporting and conveying a slice of material or disc with fluid and without physical contact, the apparatus having a head provided with a first conduit through which fluid is passed and discharged from an outlet opening thereof and in which the outlet opening of the first conduit is disposed, a flat surface extending perpendicularly to the direction of flow of the fluid through the first conduit, second conduits into which fluid is drawn through a circular array of inlet openings thereof disposed at the flat surface, the circular array of inlet openings surrounding the outlet opening, the slice or disc being supported adjacent and at a substantially constant distance from the flat surface, and a wall extending below the flat surface and surrounding the inlet openings of the second conduits and restricting lateral displacement of the slice or disc.

IBM Technical Disclosure Bulletin, volume 22, No. 8A of January 1980 discloses an apparatus for supporting and conveying a disc or wafer with fluid and without physical contact, the apparatus having a pick up provided with a circular array of first conduits through which fluid is passed and discharged from outlet openings at a flat surface extending perpendicularly to the direction of flow of fluid through the first conduits, a second conduit having an inlet opening to the flat surface and disposed centrally with respect to the outlet openings of the first conduit, the fluid being drawn into the second conduit through the inlet opening thereof, the disc or wafer being supported adjacent the flat surface. The pick up also has a wall extending below the flat surface and surrounding the inlet openings of the second conduit, the wall restricting lateral displacement of the wafer or disc, sideways air jets being applied to the edge of the wafer from the wall.

JP-58 151 536 discloses a semi-conductor wafer carrier comprising a head having a first conduit through which fluid ($N_2$ gas) is passed and having the flat surface extending perpendiclarly to the direction of flow of fluid through the conduit, a second conduit having an annular inlet opening at the flat surface of the head and surrounding the outlet opening of the first conduit, radial channels being provided in the flat surface, the fluid being drawn into the second conduit through the inlet opening, the semi-conductor wafer being supported adjacent the flat surface and without physical contact, a wall extending below the flat surface and restricting lateral displacement of the wafer.

The inventor of the present invention proposed in Japanese Patent No. 40343/1967 a method of supporting a plate with fluid without physical contact, in which a suction pipe and a delivery pipe which has an orifice near its delivery opening are assembled as the openings of suction pipe and of delivery pipe look on the same direction, a fluid is drawn into the suction pipe and at the same time a fluid is delivered from the orifice to support a plate near the openings without physical contact.

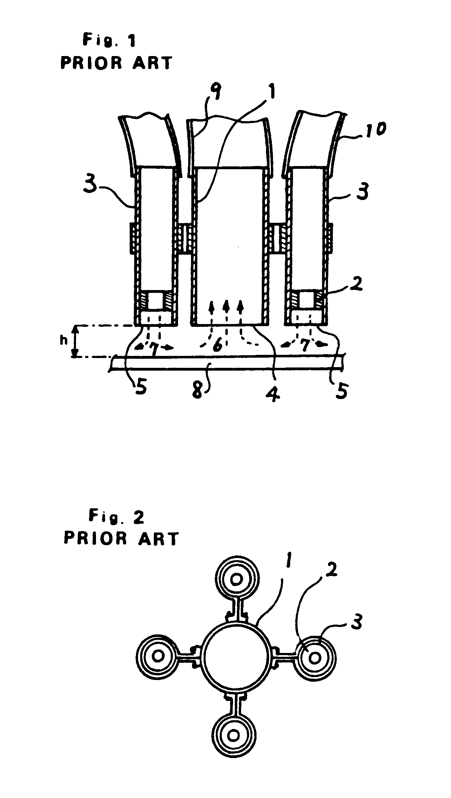

More particularly, as shown in Figs. 1 and 2, a suction pipe 1 and delivery pipes 3, each said delivery pipe 3 being provided with an orifice 2 near the opening, are assembled as both openings 4, 5 of both pipes look on the same direction, a fluid 6 such as air is drawn into the suction pipe 1 and at the same time a fluid 7 such as air is delivered from the orifices 2 as a jet flow, the negative pressure at the suction pipe 1 and the delivery pressure at the delivery pipes 3 being adjusted in proportion to the weight of plate to be supported, openings 4, 5 are faced below over a plate 8. Then the plate 8 can be supported in the air without physical contact, keeping the distance between the openings 4, 5 and the flat plate 8 constant in the range of about 0.5 mm to several mm, and the plate 8 can also be conveyed horizontally, keeping the distance h, by applying a little force to the horizontal direction. In the drawing, 9 and 10 are ducts.

In the case that the vertical delivery opening 5 is extended to the substantially perpendicular direction (horizontal) to the flow of fluid in the delivery pipe 3 to form a flat surface 11 and a plate 8 is brought under the opening 5, when the current speed of fluid 7 in the pipe 3 is constant, and when the distance of the gap h between the flat surface 11 and the upper face of plate 8 decreases, the current speed of fluid in the gap h increases, and the static pressure at the gap h decreases in accordance with Bernoulli's theorem. When this static pressure decreases to beneath atmospheric pressure and the product of this negative pressure and the area of the gap reaches to balance with the weight of plate 8, the plate 8 should float in the air without physical contact, with delivery pipe only and without suction pipe.

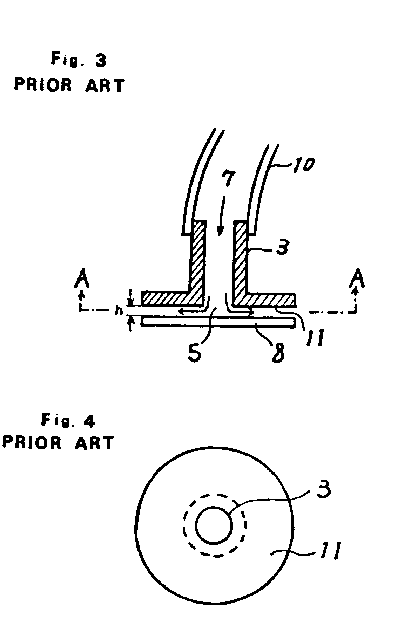

In the inventor's prior invention disclosed in Japanese patent application No. 71950/1985, the inventor has disclosed the test results of this theory, in which a plate was supported and/or conveyed with fluid without physical contact, by providing a flat surface 11 extending at opening 5 of a delivery pipe 3 to the substantially perpendicular direction to the flow direction of fluid 7 in said pipe 3, moving the opening 5 near a plate 8, and delivering fluid 7 from delivery pipe 3, as shown in Figs. 3 and 4.

## SUMMARY OF THE INVENTION

In the above-mentioned prior patent application, in the case of floating plate in air, the air 7 delivered from the gap between the flat surface 11 and the plate 8 disturbs the surrounding atmosphere to raise a dust in the room. The aforementioned plate such as silicone wafer and floppy disc has been handled in the clean room controlled to remove dust, but such a plate should be handled in the room with little disturbance of air and prevented from attaching of dust. Accordingly, the delivered fluid 7 should not be delivered from the edges of flat surface 11 and of plate 8 to the surrounding atmosphere.

The object of the present invention is to provide an apparatus for supporting and, at need, to convey a ring-shaped or annular plate in the air (and other fluids) without physical contact, preventing the disturbance of surrounding atmosphere by the fluid delivered from the gap between the flat surface 11 and the plate 8, and preventing the attachment of dust on the plate 8.

This object can be achieved by providing suction opening(s) at the periphery of the flat surface 11 in the prior application, and inhaling the delivered fluid into the suction opening (and suction pipe). Same effect can be obtained by providing a flat surface extending at opening of an inhaling pipe to the substantially perpendicular direction to the flow direction of fluid in said inhaling pipe, and providing a ring shaped or annular delivery opening of a delivery pipe around the periphery of the flat surface, to prevent the delivery of fluid from the gap between the flat surface and the plate to the surrounding atmosphere.

In accordance with a first aspect of the present invention there is provided an apparatus for supporting and/or conveying a plate with fluid and without physical contact, comprising:

a delivery pipe having an outlet opening, a flat surface, a suction pipe having an inlet opening, the inlet opening being ring-shaped or annular and surrounding the flat surface, the suction pipe having an outer wall extending below the flat surface to form a stopper for the plate when supported by the apparatus adjacent the flat surface, means for supplying the fluid through the delivery pipe and the outlet opening and for drawing the fluid into the suction pipe through the inlet opening and drawing the fluid through the suction pipe, the flat surface extending at the outlet opening substantially perpendicularly to the direction of flow of the fluid through the delivery pipe; characterised in that:

the outlet opening of the delivery pipe is ring-shaped or annular, the plate to be supported and/or conveyed being ring-shaped or annular; and the delivery pipe has an inner wall extending below the flat surface to form a stopper for the plate when supported by the apparatus adjacent the flat surface, the flat surface being ring-shaped or annular and surrounding the outlet opening.

In accordance with a second aspect of the invention there is provided an apparatus for supporting and/or conveying a plate with fluid and without physical contact, comprising:

a delivery pipe having an outlet opening, a suction pipe having an outlet opening, a flat surface, the outlet opening being ring-shaped or annular and surrounding the flat surface and the delivery pipe having an outer wall extending below the flat surface to form a stopper for the plate when supported by the apparatus adjacent the flat surface, and means for supplying the fluid through the delivery pipe and the outlet opening and for drawing the fluid into the suction pipe through the inlet opening and drawing the fluid through the suction pipe, the flat surface extending at the inlet opening substantially perpendicularly to the direction of flow of the fluid in the suction pipe; characterised in that:

the inlet opening of the suction pipe is ring-shaped or annular, the plate to be supported and/or conveyed being ring-shaped or annular; and the suction pipe has an inner wall extending below the flat surface to form a stopper for the plate when supported by the apparatus adjacent the flat surface, the flat surface being ring-shaped or annular and surrounding the inlet opening.

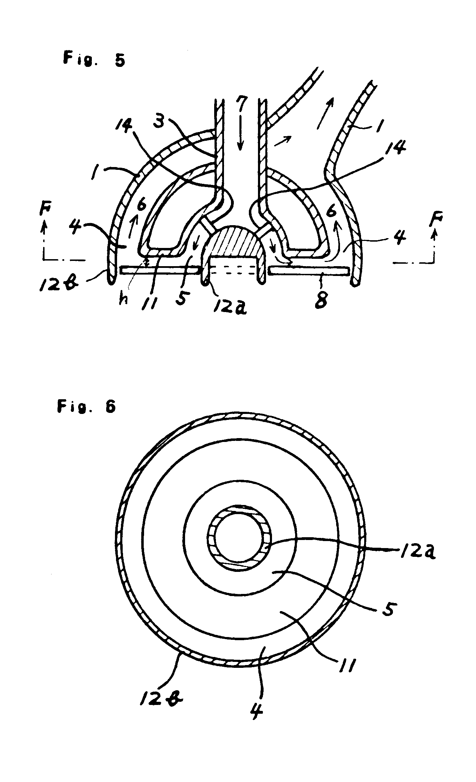

The principle of the present invention is that the fluid 7 delivered from the delivery pipe 3 forms a jet stream, passes in a small gap h between the flat surface 11 and the plate 8, and is drawn into the suction pipe 1 as shown in Fig. 5. The section area of the gap h is extremely small compared with the section area of the delivery pipe 3, and the flow speed of the fluid in the gap becomes extremely high compared with the flow speed in the delivery pipe 3, and the static pressure in the gap h is lower than the atmospheric pressure, and then the plate 8 is supported in the fluid without physical contact.

If the plate 8 would come in contact with the flat surface 11, the flow speed of fluid in the delivery pipe 3 would become zero, the plate 8 would receive the delivery pressure in the pipe 3, therefore the plate 8 cannot contact with the flat surface 11.

BRIEF DESCRIPTION OF THE DRAWINGS

Fig. 1 is a vertical sectional view of the essential part showing a prior art to support and float a plate with fluid without physical contact,

Fig. 2 is the bottom view of Fig. 1.

Fig. 3 is a vertical sectional view of the essential part showing the prior patent application,

Fig. 4 is the sectional view taken upon the line A - A of Fig. 3,

Fig. 5 is a vertical sectional view of the essential part showing an example of the present invention,

Fig. 6 is the sectional view taken upon the line F - F of Fig. 5,

Fig. 7 is a vertical sectional view of the essential part showing a modification of Fig. 5,

Fig. 8 is the sectional view taken upon the line G - G of Fig. 7,

Fig. 9 is a plan view of an example of the plate handled in the example in Fig. 5,

Fig. 10 is the sectional view taken upon the line H - H of Fig. 9,

Fig. 11 is a plan view of another example of the plate handled in the example in Fig. 5,

Fig. 12 is the sectional view taken upon the line J - J of Fig. 11,

Fig. 13 is the sectional view taken upon the line K - K of Fig. 11,

Fig. 14 is a plan view of a third example of the plate handled in the example in Fig. 5,

Examples 1 and 2 have the object to support and/or convey a plate with hole such as a hard disc with hole without physical contact, or revolving from its horizontal state to vertical state and further to reversed horizontal state. This object is achieved by providing a ring-shaped flat surface put between a ring-shaped opening of delivery pipe and a ring-shaped opening of suction pipe (these two openings being concentric). (Example 1)

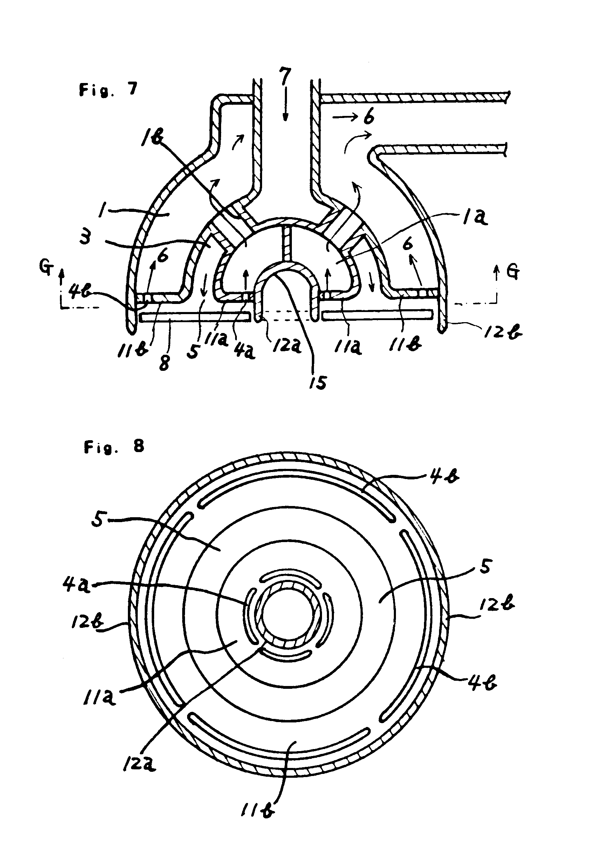

As shown in Figs. 5 and 6, a ring-shaped opening 5 of a delivery pipe 3 is extended to the perpendicular direction to form a ring-shaped flat surface 11, a cylindrical suction pipe 1 is provided, the end of which is a ring-shaped opening 4 around the flat surface 11, inner periphery of the ring-shaped opening 5 and outer periphery of the ring-shaped opening 4 are extended several mm to 20 mm lower than the flat surface 11 to form stoppers 12a, 12b, the delivery pipe 3 is connected to a delivery opening (not shown) of a fan, the suction pipe 1 is connected to a suction opening (not shown) of the fan, and the inner face of divergent part of delivery pipe 3 is supported by connecting with suitable points of inner face of outer wall by connecting rods 14, 14.

Openings 4 and 5 are moved near a round plate 8 with round hole as shown in Fig. 5, positions of inner periphery 12a of the opening 5 and the hole of plate 8 are arranged, air 7 is delivered from delivery pipe 3 and the delivered air 7 is inhaled in suction pipe 1 as shown as arrow 6. The plate 8 floats in the air without contacting with openings 4, 5 and the flat surface 11, and also can be conveyed with the whole apparatus by moving the whole apparatus.

Example 3

As shown in Figs. 7 and 8, a ring-shaped opening 5 of a delivery pipe 3 is extended to both inner and outer sides substantially perpendicular to the flowing direction of fluid 7 in the delivery pipe 3 to form a ring-shaped flat surfaces 11a, 11b, a suitable number of suction openings 4a, 4a are provided near the inner periphery of the inner flat surface 11a, a suitable number of suction openings 4b, 4b ... are provided near the outer periphery of the outer flat surface 11b, a pipe wall 15 is provided inside of the delivery pipe 3 to form a cavity 1a, said suction openings 4a, 4b connecting with cavity 1a and suction pipe 1 respectively, suction pipe 1 and cavity 1a are connected with a suitable number of connecting pipes 1b, inner periphery of flat surface 11a and outer periphery of flat surface 11b are extended downwardly several mm to 20 mm lower than the flat surfaces 11a, 11b to form stoppers 12a, 12b, the delivery pipe 3 is connected with a delivery opening (not shown) of the fan, and the suction pipe 1 is connected with a suction opening (not shown) of the fan.

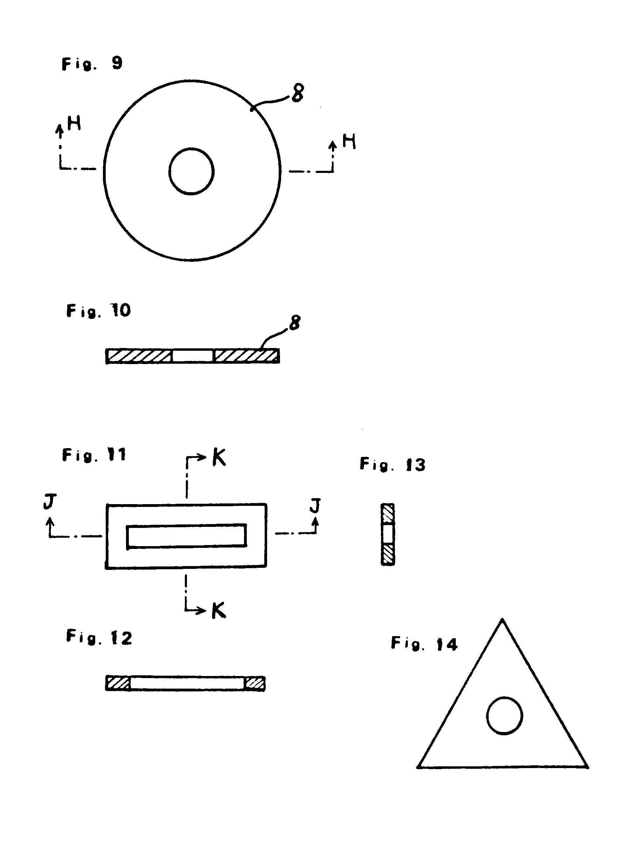

Opening 5 is moved near a round plate 8 with round hole as shown in Figs. 9 and 10, positions of inner periphery 12a of the cavity 1a and the hole of plate 8 are arranged, air 7 is delivered from delivery pipe 3 and air 6 of same volume as of air 7 is inhaled in suction pipe 1 as shown as arrows 6. The plate 8 floats in the air without contacting with openings 4a, 4b, 5 and flat surfaces 11a, 11b, holding a constant distance from them, and also can be conveyed with the whole apparatus by moving the whole apparatus. The flow directions of airs 7 and 6 can be reverse in Examples 1, 2.

In the above Examples 1 and 2, the plate 8 is described as of round figure with round hole; but any plate of different shape such as a rectangular plate with rectangular hole as shown in Figs. 11 - 13, or a triangular plate with round hole as shown in Fig. 14 can be supported and/or conveyed in the same way by fitting the shape of flat surface 11 to the shape of the plate.

Other Examples

In the above examples, an apparatus for supporting and/or conveying a plate in the air using air as fluids 6 and 7 has been disclosed, but a plate can be supported and/or conveyed using any gas other than air or water or any other liquid as fluids 6 and 7. Fluids 6 and 7 other than the fluid surrounding the plate 8 and the apparatus can also be used. For example, a plate 8 can be washed by using a liquid detergent as fluids 6 and 7, and thereafter dried by using air of room temperature or heated air as fluids 6 and 7.

EFFECT OF THE PRESENT INVENTION

In Japanese patent No. 40343/1976 as shown in Figs. 1 and 2, the combination of suction pipe and delivery pipe was essential to support a plate without physical contact.

In Japanese patent application No. 71950/1985 and in the present invention, a plate with flat upper surface can be supported near and under the opening of delivery pipe by providing a flat surface extending from the opening of delivery pipe, and the plate can be conveyed with the apparatus when some stoppers are provided extending below the periphery of the flat surface. The plate having a flat upper surface can be conveyed to the horizontal direction with the apparatus by moving the apparatus.

In the aforesaid prior application, delivered air 7 is delivered from the gap between the flat surface 11 and the plate 8, the air 7 disturbs the atmosphere and the plate 8 is in danger of being stained with minute particles of dust. In the present invention, the delivered air 7 from the gap between the flat surface 11 and the plate 8 is immediately inhaled into the suction pipe 1 and does not spread into the atmosphere, dusts in room cannot be blown up and attach on the plate.

Two fans may be used, one for delivering the air 7 in the delivery pipe 3 and another for inhaling the air 6 into the suction pipe; or only one fan may be used for both delivering and inhaling. If only one fan is used, the flow of air forms a closed circuit, i. e., delivery pipe 3 to suction pipe 1 to fan to delivery pipe 3 (but a little atmospheric air can enter the circuit from the gap between the stopper 12 and the plate 8), and little dust can enter into the circulating air from atmosphere.

When starting the operation of supporting a plate, it is not preferable to move the opening 5 of delivery pipe 3 near the plate 8 after starting the fan, as the delivered air disturbs the surrounding atmosphere, but it is preferable to start the fan after the opening 5 has been near the plate 8.

The present invention is extremely effective for conveying and/or handling of ring-shaped or annular plates, such as semiconductor wafer, magnetic disc, mirror, which should not be marred or stained and cannot be touched with hand or gripper, in their producing or packing process.

**Claims**

1. An apparatus for supporting and/or conveying a plate (8) with fluid (7) and without physical contact, comprising:
a delivery pipe (3) having an outlet opening (5), a flat surface (11), a suction pipe (1) having an inlet opening (4), the inlet opening (4) being ring-shaped or annular and surrounding the flat surface (11), the suction pipe (1) having an outer wall extending below the flat surface (11) to form a stopper (12b) for the plate (8) when supported by the apparatus adjacent the flat surface (11), means for supplying the fluid (7) through the delivery pipe (3) and the outlet opening (5) and for drawing the fluid (6) into the suction pipe (1) through the inlet opening (4) and drawing the fluid (6) through the suction pipe, the flat surface (11) extending at the outlet opening (5) substantially perpendicularly to the direction of flow of the fluid (7) through the delivery pipe (3); characterised in that:
the outlet opening (5) of the delivery pipe (3) is ring-shaped or annular, the plate (8) to be supported and/or conveyed being ring-shaped or annular; and the delivery pipe (3) has an inner wall extending below the flat surface (11) to form a stopper (12a) for the plate (8) when supported by the apparatus adjacent the flat surface (11), the flat surface (11) being ring-shaped or annular and surrounding the outlet opening (5).

2. An apparatus for supporting and/or conveying a plate (8) with fluid (7) and without physical contact, comprising:
a delivery pipe (3) having an outlet opening (5), a suction pipe (1) having an outlet opening (4), a flat surface (11), the outlet opening (5) being ring-shaped or annular and surrounding the flat surface (11) and the delivery pipe (3) having an outer wall extending below the flat surface (11) to form a stopper (12b) for the plate (8) when supported by the apparatus adjacent the flat surface (11), and means for supplying the fluid (7) through the delivery pipe (3) and the outlet opening (5) and for drawing the fluid (6) into the suction pipe (1) through the inlet opening (4) and drawing the fluid (6) through the suction pipe (1), the flat surface (11) extending at the inlet opening (4) substantially perpendicularly to the direction of flow of the fluid (6) in the suction pipe (1); characterised in that:

the inlet opening (4) of the suction pipe (1) is ring-shaped or annular, the plate (8) to be supported and/or conveyed being ring-shaped or annular; and the suction pipe (1) has an inner wall extending below the flat surface (11) to form a stopper for the plate (8) when supported by the apparatus adjacent the flat surface (11), the flat surface (11) being ring-shaped or annular and surrounding the inlet opening (4).

3. An apparatus according to either of claims 1 and 2, wherein at least one of the annular openings is circumferentially interrupted.

4. An apparatus according to any of claims 1 to 3, further comprising means for recirculating the fluid (6) drawn into the suction pipe (1) to the delivery pipe (3).

**Patentansprüche**

1. Vorrichtung zum Stützen und/oder Befördern einer Platte (8) mit Fluid (7) und ohne physischen Kontakt, umfassend:

ein Zuführungsrohr (3) mit einer Auslaßöffnung (5), eine flache Oberfläche (11), ein Saugrohr (1) mit einer Einlaßöffnung (4), wobei die Einlaßöffnung (4) ringförmig oder -artig ist und die flache Oberfläche (11) umgibt, wobei das Saugrohr (1) eine sich bis unter die flache Oberfläche (11) erstreckende Außenwand zur Bildung eines Anschlags (12b) für die Platte (8), wenn sie von der Vorrichtung neben der flachen Oberfläche (11) gestützt wird, aufweist, eine Einrichtung zur Lieferung des Fluids (7) durch das Zuführungsrohr (3) und die Auslaßöffnung (5) hindurch und zum Ziehen des Fluids (6) durch die Einlaßöffnung (4) in das Saugrohr (1) und Ziehen des Fluids (6) durch das Saugrohr, wobei die flache Oberfläche (11) sich an der Auslaßöffnung (5) im wesentlichen senkrecht zur Strömungsrichtung des Fluids (7) durch das Zuführungsrohr (3) hindurch erstreckt; dadurch gekennzeichnet, daß die Auslaßöffnung (5) des Zuführungsrohrs (3) ringförmig oder -artig ist, wobei die zu stützende und/oder zu befördernde Platte (8) ringförmig oder -artig ist; und das Zuführungsrohr (3) eine sich bis unter die flache Oberfläche (11) erstreckende Innenwand zur Bildung eines Anschlags (12a) für die Platte (8), wenn sie von der Vorrichtung neben der flachen Oberfläche (11) gestützt wird, aufweist, wobei die flache Oberfläche (11) ringförmig oder -artig ist und die Auslaßöffnung (5) umgibt.

2. Vorrichtung zum Stützen und/oder Befördern einer Platte (8) mit Fluid (7) und ohne physischen Kontakt, umfassend:

ein Zuführungsrohr (3) mit einer Auslaßöffnung (5), ein Saugrohr (1) mit einer Auslaßöffnung (4), eine flache Oberfläche (11), wobei die Auslaßöffnung (5) ringförmig oder -artig ist und die flache Oberfläche (11) umgibt und das Zuführungsrohr (3) eine sich bis unter die flache Oberfläche (11) erstreckende Außenwand zur Bildung eines Anschlags (12b) für die Platte (8), wenn sie von der Vorrichtung neben der flachen Oberfläche (11) gestützt wird, aufweist, und eine Einrichtung zur Lieferung des Fluids (7) durch das Zuführungsrohr (3) und die Auslaßöffnung (5) hindurch und zum Ziehen des Fluids (6) durch die Einlaßöffnung (4) in das Saugrohr (1) und Ziehen des Fluids (6) durch das Saugrohr (1), wobei die flache Oberfläche (11) sich an der Einlaßöffnung (4) im wesentlichen senkrecht zur Strömungsrichtung des Fluids (6) im Saugrohr (1) erstreckt; dadurch gekennzeichnet, daß

die Einlaßöffnung (4) des Saugrohrs (1) ringförmig oder -artig ist, wobei die zu stützende und/oder zu befördernde Platte (8) ringförmig oder -artig ist; und das Saugrohr (1) eine sich bis unter die flache Oberfläche (11) erstreckende Innenwand zur Bildung eines Anschlags für die Platte (8), wenn sie von der Vorrichtung neben der flachen Oberfläche (11) gestützt wird, aufweist, wobei die flache Oberfläche (11) ringförmig oder -artig ist und die Einlaßöffnung (4) umgibt.

3. Vorrichtung nach einem der Ansprüche 1 und 2, wobei mindestens eine der ringartigen Öffnungen umfangsmäßig unterbrochen ist.

4. Vorrichtung nach einem der Ansprüche 1 bis 3, welche ferner eine Einrichtung für den Wiederumlauf zum Zuführungsrohr (3) des in das Saugrohr (1) gezogenen Fluids (6) umfaßt.

**Revendications**

1. Appareil pour le support et/ou le transport d'une plaque (8) par du fluide (7) et sans contact physique, comprenant :

un tuyau (3) de décharge présentant une ouverture (5) de sortie, une surface plate (11), un tuyau (1) d'aspiration présentant une ouverture (4) d'entrée, l'ouverture (4) d'entrée étant en forme de bague ou annulaire et entourant la surface plate (11), le tuyau (1) d'aspiration présentant une paroi extérieure s'étendant en dessous de la surface plate (11) pour former un arrêt (12b) pour la plaque (8) lorsqu'elle est supportée par l'appareil en position voisine de la surface plate (11), un moyen pour fournir le fluide (7) à travers le tuyau (3) de décharge et l'ouverture (5) de sortie et pour attirer le fluide (6) dans le tuyau (1) d'aspiration à travers l'ouverture (4) d'entrée et attirer le fluide (6) à travers le tuyau d'aspiration, la surface plate (11) s'étendant au niveau de l'ouverture (5) de sortie sensiblement perpendiculairement par rapport au sens d'écoulement du fluide (7) à travers le tuyau (3) de décharge ; caractérisé en ce que :

l'ouverture (5) de sortie du tuyau (3) de décharge est en forme de bague ou annulaire, la plaque (8) devant être supportée et/ou transportée étant en forme de bague ou annulaire ; et le tuyau (3) de décharge présente une paroi intérieure s'étendant en dessous de la surface plate (11) pour former un arrêt (12a) pour la plaque (8) lorsqu'elle est supportée par l'appareil en position voisine de la surface plate (11), la surface plate (11) étant en forme de bague ou annulaire et entourant l'ouverture (5) de sortie.

2. Appareil pour le support et/ou le transport d'une plaque (8) par du fluide (7) et sans contact physique, comprenant :

un tuyau (3) de décharge présentant une ouverture (5) de sortie, un tuyau (1) d'aspiration présentant une ouverture (4) de sortie, une surface plate (11), l'ouverture (5) de sortie étant en forme de bague ou annulaire et entourant la surface plate (11) et le tuyau (3) de décharge présentant une paroi extérieure s'étendant en dessous de la surface plate (11) pour former un arrêt (12b) pour la plaque (8) lorsqu'elle est supportée par l'appareil en position voisine de la surface plate (11), et un moyen pour fournir le fluide (7) à travers le tuyau (3) de décharge et l'ouverture (5) de sortie et pour attirer le fluide (6) dans le tuyau (1) d'aspiration à travers l'ouverture (4) d'entrée et attirer le fluide (6) à travers le tuyau (1) d'aspiration, la surface plate (11) s'étendant au niveau de l'ouverture (4) d'entrée sensiblement perpendiculairement par rapport au sens d'écoulement du fluide (6) dans le tuyau (1) d'aspiration ; caractérisé en ce que :

l'ouverture (4) d'entrée du tuyau (1) d'aspiration est en forme de bague ou annulaire, la plaque (8) devant être supportée et/ou transportée étant en forme de bague ou annulaire ; et le tuyau (1) d'aspiration présente une paroi intérieure s'étendant en dessous de la surface plate (11) pour former un arrêt pour la plaque (8) lorsqu'elle est supportée par l'appareil en position voisine de la surface plate (11), la surface plate (11) étant en forme de bague ou annulaire et entourant l'ouverture (4) d'entrée.

3. Appareil selon l'une ou l'autre des revendications 1 et 2, dans lequel au moins une des ouvertures annulaires est interrompue sur sa circonférence.

4. Appareil selon l'une quelconque des revendications 1 à 3, comprenant en outre un moyen pour la remise en circulation du fluide (6) attiré dans le tuyau (1) d'aspiration, vers le tuyau (3) de décharge.

Fig. 1
PRIOR ART

Fig. 2
PRIOR ART

8

**Fig. 3**
**PRIOR ART**

**Fig. 4**
**PRIOR ART**

Fig. 5

Fig. 6

Fig. 7

Fig. 8

Fig. 9

8

H     H

Fig. 10

8

Fig. 11

K

J     J

K

Fig. 13

Fig. 12

Fig. 14